(19) Europäisches Patentamt
European Patent Office
Office européen des brevets

(11) Veröffentlichungsnummer : **0 094 915**
**B1**

(12) # EUROPÄISCHE PATENTSCHRIFT

(45) Veröffentlichungstag der Patentschrift : **21.01.87**

(51) Int. Cl.[4] : **G 03 C 1/68**, C 08 F 4/42, C 08 G 59/68, C 08 G 65/10

(21) Anmeldenummer : **83810207.7**

(22) Anmeldetag : **13.05.83**

(54) **Härtbare, Metallocenkomplexe enthaltende Zusammensetzungen, daraus erhältliche aktivierte Vorstufen und deren Verwendung.**

(30) Priorität : **19.05.82 GB 8214610**

(43) Veröffentlichungstag der Anmeldung : **23.11.83 Patentblatt 83/47**

(45) Bekanntmachung des Hinweises auf die Patenterteilung : **21.01.87 Patentblatt 87/04**

(84) Benannte Vertragsstaaten : **CH DE FR GB IT LI NL**

(56) Entgegenhaltungen :
**DE-A- 2 025 814**
**FR-A- 2 269 552**
**GB-A- 2 051 071**
**US-A- 4 225 691**
**Chem. Comm. 1971, 1071**
**Can. J. Chem. 57, 933 (1979)**
**J. Organomet. Chem. 88, 207 (1975)**
**Die Akte enthält technische Angaben, die nach dem Eingang der Anmeldung eingereicht wurden und die nicht in dieser Patentschrift enthalten sind.**

(73) Patentinhaber : **CIBA-GEIGY AG**
**Klybeckstrasse 141**
**CH-4002 Basel (CH)**

(72) Erfinder : **Meier, Kurt, Dr.**
**Ulmenstrasse 11**
**CH-4123 Allschwil (CH)**
Erfinder : **Bühler, Niklaus, Dr.**
**Gartenweg 30**
**CH-4310 Rheinfelden (CH)**
Erfinder : **Zweifel, Hans, Dr.**
**Lothringerstrasse 93**
**CH-4056 Basel (CH)**
Erfinder : **Berner, Godwin, Dr.**
**Waldhofstrasse 70**
**CH-4310 Rheinfelden (CH)**
Erfinder : **Lohse, Friedrich, Prof. Dr.**
**Buchenstrasse 23**
**CH-4104 Oberwil (CH)**

**EP 0 094 915 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Vorliegende Erfindung betrifft neuartige, Metallocenkomplexe enthaltende härtbare Zusammensetzungen, die daraus erhältlichen aktivierten Vorstufen (aktive Typen) und deren Verwendung.

Verschiedene Iodonium-, Sulfonium- und Diazoniumsalze sind aus der Literatur als Photoinitiatoren für kationisch polymerisierbare organische Materialien bekannt (siehe beispielsweise DE-B-25 18 639, J. Polym. Sci., Polymer Chemistry Ed., *17*, 1059 (1979), Makromol. Chem., Suppl. *3*, 348 (1979), DE-A-25 20 489, 28 54 011 und 30 21 376, US-A-4 210 449 und GB-A-2 046 269). Wegen ihres verhältnismässig tiefliegenden Absorptionsbereichs (etwa 190 bis 400 nm) erfordern diese bekannten Photoinitiatoren die Verwendung von Sensibilisatoren wie farbigen polycyclischen Kohlenwasserstoffen, z. B. Perylenfarbstoffe, aromatische Amine, Benzoinalkyläther oder Alkoxyacetophenone, zur Härtung kationisch polymerisierbarer Systeme unter Lichteinwirkung. Die Heisshärtung von solche Photoinitiatoren enthaltenden Systemen wird zweckmässig in Gegenwart von Reduktionsmitteln wie Kupfer-, Zinn-, Eisen- oder Kobaltsalzen, Thiophenolen, Ascorbinsäure und dergleichen durchgeführt.

In der DE-A-2 025 814 werden Epoxidharzmassen enthaltend ein Metallocen, bevorzugt Ferrocen, als latente Heisshärter beschrieben. Eine Strahlungshärtung wird nicht vorgeschlagen. Die organometallischen Verbindungen enthalten zwei Cyclopentadienylanionen, aber kein $\pi$-Aren als Liganden. Die Herstellung von Eisen-Aren Komplexen durch Ligandenaustausch in Gegenwart von Lewis-Säuren wird in Chem. Comm., 1971, 1071 und in Can. J. Chem., *57*, 933 (1979) beschrieben. Als Lewis-Säuren werden $AlCl_3$ oder $BF_3$-Etherat eingesetzt.

Aus J. Organomet. Chem., *88*, 207 (1975) ist die stereospezifische Ringprotonierung von Bisindenyleisen und die nachfolgende Isolierung des entsprechenden Hexafluorphosphatsalzes bekannt. In keiner dieser Publikationen ist ein Hinweis auf den Einsatz der Metallocensalze als Initiatoren der kationischen Polymerisation zu finden.

Die Aufgabe der vorliegenden Erfindung besteht darin, neuartige härtbare Zusammensetzungen zur Verfügung zu stellen, die ohne Zusatz von Sensibilisatoren unter der Einwirkung von Licht und/oder Hitze gehärtet werden können.

Gegenstand der Erfindung sind dementsprechend härtbare Zusammensetzungen enthaltend

A) ein kationisch polymerisierbares organisches Material und

B) mindestens eine Verbindung der Formel I

$$[(R^1)\ (R^2\ M)_a]^{+an}\ \frac{an}{q}\ [LQ_m]^{-q} \qquad (I)$$

worin a 1 oder 2 sowie n und q unabhängig voneinander je eine ganz Zahl von 1 bis 3 sind, M das Kation eines einwertigen bis dreiwertigen Metalls aus Gruppe IVb bis VIIb, VIII oder Ib des Periodensystems darstellt, m eine der Wertigkeit von L + q entsprechende ganze Zahl ist und Q ein Halogenatom, L ein zweiwertiges bis siebenwertiges Metall oder Nichtmetall, $R^1$ ein $\pi$-Aren und $R^2$ ein $\pi$-Aren oder das Anion eines $\pi$-Arens bedeuten.

Als $\pi$-Arene $R^1$ und $R^2$ kommen insbesondere aromatische Gruppen mit 6 bis 24 Kohlenstoffatomen oder heteroaromatische Gruppen mit 3 bis 30 Kohlenstoffatomen in Betracht, wobei diese Gruppen gegebenenfalls durch gleiche oder verschiedene einwertige Reste wie Halogenatome, vorzugsweise Chlor- oder Bromatome, oder $C_1$-$C_8$-Alkyl-, $C_1$-$C_8$-Alkoxy-, Cyan-, $C_1$-$C_8$-Alkylthio-, $C_2$-$C_6$-Monocarbonsäurealkylester-, Phenyl-, $C_2$-$C_5$-Alkanoyl- oder Benzoylgruppen einfach oder mehrfach substituiert sein können. Diese $\pi$-Arengruppen können einkernige, kondensierte mehrkernige oder unkondensierte mehrkernige Systeme darstellen, wobei in den zuletzt genannten Systemen die Kerne direkt oder über Brückenglieder wie —S— oder —O— verknüpft sein können.

$R^2$ als das Anion eines $\pi$-Arens kann ein Anion eines $\pi$-Arens der obengenannten Art sein, zum Beispiel das Indenylanion und insbesondere das Cyclopentadienylanion, wobei auch diese Anionen gegebenenfalls durch gleiche oder verschiedene einwertige Reste wie $C_1$-$C_8$-Alkyl-, $C_2$-$C_6$-Monocarbonsäurealkylester-, Cyan-, $C_2$-$C_5$-Alkanoyl- oder Benzoylgruppen einfach oder mehrfach substituiert sein können.

Die Alkyl-, Alkoxy-, Alkylthio-, Monocarbonsäurealkylester- und Alkanoylsubstituenten können dabei geradkettig oder verzweigt sein. Als typische Alkyl-, Alkoxy-, Alkylthio-, Monocarbonsäurealkylester- bzw. Alkanoylsubstituenten seien Methyl, Aethyl, n-Propyl, Isopropyl, n-Butyl, sek.-Butyl, tert.-Butyl, n-Pentyl, n-Hexyl und n-Octyl, Methoxy, Aethoxy, n-Propoxy, Isopropoxy, n-Butoxy, n-Hexyloxy und n-Octyloxy, Methylthio, Aethylthio, n-Propylthio, Isopropylthio, n-Butylthio, n-Pentylthio und n-Hexylthio, Carbonsäuremethyl-, -äthyl-, -n-propyl-, -isopropyl-, -n-butyl- und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. Als substituierte $\pi$-Arene oder Anionen von substituierten $\pi$-Arenen werden solche bevorzugt, die einen oder zwei der obengenannten Substituenten, insbesondere Chlor- oder Bromatome, Methyl-, Aethyl-, Methoxy-, Aethoxy-, Cyan-, Carbonsäuremethyl- oder -äthylestergruppen und Acetylgruppen, enthalten.

Als $R^1$ und $R^2$ können gleiche oder verschiedene $\pi$-Arene vorliegen. Als heteroaromatische $\pi$-Arene eignen sich S-, N- und/oder O-Atome enthaltende Systeme. Heteroaromatische $\pi$-Arene, die S- und/oder O-Atome enthalten, sind bevorzugt. Beispiele für geeignete $\pi$-Arene sind Benzol, Toluol, Xylole, Aethylbenzol, Methoxybenzol, Aethoxybenzol, Dimethoxybenzol, p-Chlortoluol, Chlorbenzol, Brombenzol, Dichlorbenzol, Acetylbenzol, Trimethylbenzol, Trimethoxybenzol, Naphthalin, 1,2-Dihydronaphthalin, 1,2,3,4-Tetrahydronaphthalin, Methylnaphthaline, Methoxynaphthaline, Aethoxynaphthaline, Chlornaphthaline, Bromnaphthaline, Biphenyl, Inden, Biphenylen, Fluoren, Phenanthren, Anthracen, 9,10-Dihydroanthracen, Triphenylen, Pyren, Naphthacen, Coronen, Thiophen, Chromen, Xanthen, Thioxanthen, Benzothiophen, Naphthothiophen, Thianthren, Diphenylenoxyd, Diphenylensulfid, Acridin und Carbazol.

Wenn a 2 ist, stellt $R^2$ vorzugsweise je das Anion eines $\pi$-Arens dar, und M ist jeweils das gleiche Metallatom. Beispiele für Anionen substituierter $\pi$-Arene sind die Anionen des Methyl-, Aethyl-, n-Propyl- und n-Butylcyclopentadiens, die Anionen des Dimethylcyclopentadiens, der Cyclopentadiencarbonsäuremethyl- und -äthylester sowie des Acetylcyclopentadiens, Propionylcyclopentadiens, Cyancyclopentadiens und Benzoylcyclopentadiens. Bevorzugte Anionen sind das Anion des unsubstituierten Indens und insbesondere des unsubstituierten Cyclopentadiens.

Bevorzugt hat a den Wert 1, und $R^1$ steht für Benzol, Toluol, Xylol, Methoxybenzol, Chlorbenzol, p-Chlortoluol, Naphthalin, Methylnaphthalin, Chlornaphthalin, Methoxynaphthalin, Biphenyl, Inden, Pyren oder Diphenylensulfid, und $R^2$ steht für das Anion des Cyclopentadiens, Acetylcyclopentadiens oder Indens oder für Benzol, Toluol, Xylol, Trimethylbenzol, Naphthalin oder Methylnaphthalin.

M ist beispielsweise $Ti^+$, $Ti^{2+}$, $Ti^{3+}$, $Zr^+$, $Zr^{2+}$, $Zr^{3+}$, $Hf^+$, $Hf^{2+}$, $Hf^{3+}$, $Nb^+$, $Nb^{2+}$, $Nb^{3+}$, $Cr^+$, $Mo^+$, $Mo^{2+}$, $W^+$, $W^{2+}$, $Mn^+$, $Mn^{2+}$, $Re^+$, $Fe^{2+}$, $Co^{2+}$, $Co^{3+}$, $Ni^{2+}$ oder $Cu^{2+}$. Vorzugsweise ist M ein Chrom-, Kobalt-, Mangan-, Wolfram- oder Molybdänkation, insbesondere ein Eisenkation, und besonders bevorzugt $Fe^{2+}$. Besonders bevorzugt sind solche Komplexe der Formel I, worin a 1 ist, $R^1$ für $\eta^6$-Pyren oder $\eta^6$-Naphthalin und $R^2$ für das Anion des $\eta^5$-Cyclopentadiens stehen, n vorzugsweise 1 oder 2, insbesondere 1, und q vorzugsweise 1 sind.

Beispiele für geeignete Metalle oder Nichtmetalle L sind Sb, Fe, Sn, Bi, Al, Ga, In, Ti, Zr, Sc, V, Cr, Mn und Cu ; Lanthanide wie Ce, Pr und Nd oder Actinide wie Th, Pa, U oder Np. Geeignete Nichtmetalle sind insbesondere B, P und As. L ist vorzugsweise P, As, B oder Sb, wobei P besonders bevorzugt wird.

Komplexe Anionen $[LQ_m]^{-q}$ sind beispielsweise $BF_4^-$, $PF_6^-$, $AsF_6^-$, $SbF_6^-$, $FeCl_4^-$, $SnCl_6^{2-}$, $SbCl_6^-$ und $BiCl_6^-$. Die besonders bevorzugten komplexen Anionen sind $SbF_6^-$, $BF_4^-$, $AsF_6^-$ und $PF_6^-$.

Die Verbindungen der Formel I lassen sich nach an sich bekannten Methoden herstellen, zum Beispiel durch Umsetzung einer Verbindung der Formel II

$$[(R^1)\,(R^2\,M)_a]^{+an}\,\frac{an}{q}\,[X]^{-q} \qquad \text{(II)}$$

mit einem Salz eines Anions $[LQ_m]^{-q}$, worin a, m, n, q, $R^1$, $R^2$, M und L die unter der Formel I angegebenen Bedeutungen haben und $[X]^{-q}$ ein von $[LQ_m]^{-q}$ verschiedenes Anion darstellt.

Sowohl die Verbindungen der Formel II als auch die Verbindungen der Formel III

$$[(R^{1\prime})\,(R^2\,M)_a] \qquad \text{(III)}$$

worin a und M die oben angegebenen Bedeutungen haben und $R^{1'}$ ein $\pi$-Aren oder das Anion eines $\pi$-Arens und $R^2$ ein Anion eines $\pi$-Arens darstellen, lassen sich durch Umsetzung gleicher oder verschiedener $\pi$-Arene in Gegenwart einer Lewis-Säure mit einem Salz eines Metalls aus Gruppe IVb bis VIIb, VIII oder Ib des Periodensystems herstellen. Die Verbindungen der Formeln I, II und III eignen sich auch zur Durchführung eines Ligandenaustauschs, indem man diese Verbindungen in Gegenwart einer Lewis-Säure mit einem von $R^1$ und/oder $R^2$ bzw. $R^{1'}$ verschiedenen $\pi$-Aren umsetzt. In diesen Fällen ist n vorzugsweise 2 und besonders bevorzugt 1.

Verbindungen der Formel I, worin L ein Metall ist, lassen sich auch durch Umsetzung gleicher oder verschiedener $\pi$-Arene in Gegenwart einer Lewis-Säure mit einem geeigneten Salz eines Metalls aus Gruppe IVb bis VIIb, VIII oder Ib des Periodensystems, z. B. einem Titan-, Zirkon-, Chrom-, Mangan- und insbesonderes einem Eisensalz, herstellen. Schliesslich kann man auch Verbindungen der Formel I in herkömmlicher Weise durch Anionenaustausch in Komplexe der Formel I mit einem verschiedenen Anion $[LQ_m]^{-q}$ unwandeln.

Bei einer bevorzugten Ausführungsform werden ungeladene $\pi$-Komplexe der Formel III, z. B. Ferrocen oder Bis-($\eta^5$-indenyl)-eisen (II) als Ausgangsstoffe eingesetzt, und diese werden durch Ligandenaustausch in einen Komplex der Formel II umgewandelt, der anschliessend mit einem Salz eines Anions $[LQ_m]^{-q}$ zur Reaktion gebracht wird. Der dabei als Zwischenprodukt erhaltene Komplex der Formel II wird üblicherweise nicht isoliert.

Als Salze von Anionen $[LQ_m]^{-q}$ eignen sich beispielsweise Alkali-, Erdalkali- oder Ammoniumsalze. Es wird bevorzugt, Alkalisalze und besonders bevorzugt Natrium- und Kaliumsalze zu verwenden.

Als Lewis-Säuren für die oben beschriebenen Reaktion eignen sich beispielsweise $AlCl_3$, $AlBr_3$, $BF_3$, $SnCl_4$ und $TiCl_4$, wobei $AlCl_3$ bevorzugt wird. Es kann vorteilhaft sein, die Ligandenaustauschreaktionen unter Zusatz eines Reduktionsmittels, z. B. Aluminium oder Magnesium, zum Reaktionsgemisch durchzuführen, oder nachträglich dem Reaktionsgemisch ein Reduktionsmittel, z. B. $Na_2SO_3$ oder Ascorbinsäure, zuzusetzen. Aluminium wird als Reduktionsmittel bevorzugt. Die Ligandenaustauschreaktionen werden zweckmässig in einem inerten organischen Lösungsmittel durchgeführt. Geeignete Lösungsmittel sind beispielsweise aliphatische oder cycloaliphatische Kohlenwasserstoffe wie Octan, Nonan, Decan und Cyclohexan. Gewünschtenfalls kann man auch einen Ueberschuss π-Aren als Lösungsmittel einsetzen.

Die Umsetzung der Verbindungen der Formel II mit einem Salz eines Anions $[LQ_m]^{-q}$ und die Anionenaustauschumwandlung von Verbindungen der Formel I werden zweckmässig in einem wässrigen oder wässrig-alkoholischen Medium durchgeführt, z. B. in Gemischen aus Wasser und Methanol oder Aethanol. Die Salze der Anionen $[LQ_m]^{-q}$ werden in mindestens stöchiometrischen Mengen, aber vorzugsweise im Ueberschuss eingesetzt.

Gegenstand der Erfindung ist ferner ein Verfahren zur Herstellung von Verbindungen der Formel Ia

$$[R^1\ FeR^{2'}]_q^{\oplus}\ [LQ_m]^{q\ominus} \qquad (Ia)$$

worin $R^1$, L, Q, m und q die oben erwähnte Bedeutung besitzen und $R^{2'}$ ein Anion eines π-Arens darstellt, durch Umsetzung eines ungeladenen π-Komplexes der Formel IIIa

$$[(R^{2'})_2\ Fe] \qquad (IIIa)$$

mit einem π-Aren $R^1$ in Gegenwart von Aluminium und einer Lewissäure und nachfolgender Behandlung mit einem Salz des Anions $[LQ_m]^{q-}$, dadurch gekennzeichnet, dass als Lewissäure $TiCl_4$ eingesetzt wird.

Die neuen Verbindungen ($\eta^6$-Toluol) ($\eta^5$-indenyl)-eisen-(II)-hexafluorophosphat, ($\eta^6$-Pyren) ($\eta^5$-cyclopentadienyl)-eisen-(II)-hexafluoroantimonat, ($\eta^6$-Naphthalin) ($\eta^5$-cyclopentadienyl)-eisen-(II)-hexafluoroantimonat, ($\eta^5$-Naphthalin) ($\eta^5$-cyclopentadienyl)-eisen-(II)-hexafluoroarsenat, ($\eta^6$-2-Methoxynaphthalin) ($\eta^5$-cyclopentadienyl)-eisen-(II)-hexafluorophosphat, ($\eta^6$-Diphenylensulfid) ($\eta^5$-cyclopentadienyl)-eisen-(II)-hexafluorophosphat, ($\eta^6$-Perylen) ($\eta^5$-cyclopentadienyl)-eisen-(II)-hexafluorophosphat und Bis-($\eta^6$-1-methylnaphthalin)-eisen-(II)-hexafluorophosphat stellen ebenfalls einen Gegenstand der vorliegenden Erfindung dar.

Für die erfindungsgemässen härtbaren Zusammensetzungen geeignete, kationisch polymerisierbare organische Materialien sind beispielsweise solche der folgenden Arten, wobei diese für sich allein oder als Gemische von mindestens zwei Komponenten eingesetzt werden können :

I. Aethylenisch ungesättigte Verbindungen, die nach einem kationischen Mechanismus polymerisierbar sind. Dazu gehören

1. Mono- und Diolefine, z. B. Isobutylen, Butadien, Isopren, Styrol, α-Methylstyrol, Divinylbenzole, N-Vinylpyrrolidon, N-Vinylcarbazol und Acrolein.

2. Vinyläther, z. B. Methylvinyläther, Isobutylvinyläther, Trimethylolpropantrivinyläther, Aethylenglykoldivinyläther ; cyclische Vinyläther, z. B. 3,4-Dihydro-2-formyl-2H-pyran (dimeres Acrolein) un der 3,4-Dihydro-2H-pyran-2-carbonsäureester des 2-Hydroxymethyl-3,4-dihydro-2H-pyrans.

3. Vinylester, z. B. Vinylacetat und Vinylstearat.

II. Kationisch polymerisierbare heterocyclische Verbindungen, z. B. Aethylenoxyd, Propylenoxyd, Epichlorhydrin, Glycidyläther einwertiger Alkohole oder Phenole, z. B. n-Butylglycidyläther, n-Octylglycidyläther, Phenylglycidyläther und Kresylglycidyläther ; Glycidylacrylat, Glycidylmethacrylat, Styroloxyd und Cyclohexenoxyd ; Oxetane wie 3,3-Dimethyloxetan und 3,3-Di-(chlormethyl)-oxetan ; Tetrahydrofuran ; Dioxolane, Trioxan und 1,3,6-Trioxacyclooctan ; Lactone wie β-Propiolacton, γ-Valerolacton und ε-Caprolacton ; Thiirane wie Aethylensulfid und Propylensulfid ; Azetidine wie N-Acylazetidine, z. B. N-Benzoylazetidin sowie die Addukte von Azetidin mit Diisocyanaten, z. B. Toluylen-2,4- und -2,6-diisocyanat und 4,4'-Diaminodiphenylmethandiisocyanat ; Epoxiharze ; lineare und verzweigte Polymere mit Glycidylgruppen in den Seitenketten, z. B. Homo- und Copolymere von Polyacrylat- und Polymethacrylatglycidylestern.

Besonders wichtige unter diesen obengenannten polymerisierbaren Verbindungen sind die Epoxiharze und insbesondere die Di- und Polyepoxide und Epoxidharzpräpolymere der zur Herstellung vernetzter Epoxiharze verwendeten Art. Die Di- und Polyepoxide können aliphatische, cycloaliphatische oder aromatische Verbindungen sein. Beispiele für solche Verbindungen sind die Glycidyläther und β-Methylglycidyläther aliphatischer oder cycloaliphatischer Diole oder Polyole, zum Beispiel solche des Aethylenglykols, Propan-1,2-diols, Propan-1,3-diols, Butan-1,4-diols, Diäthylenglykols, Polyäthylenglykols, Polypropylenglykols, Glycerins, Trimethylolpropans oder 1,4-Dimethylolcyclohexans oder des 2,2-Bis-(4-hydroxycyclohexyl)-propans und N,N-Bis-(2-hydroxyäthyl)-anilins ; die Glycidyläther von Di- und Polyphenolen, beispielsweise Resorcin, 4,4'-Dihydroxydiphenylmethan, 4,4'-Dihydroxydiphenyl-2,2-propan, Novolake und 1,1,2,2-Tetrakis-(4-hydroxyphenyl)-äthan. Weitere Beispiele sind N-Glycidylverbindungen, z. B. die Diglycidylverbindungen des Aethylenharnstoffs, 1,3-Propylenharnstoffs oder 5-Dimethylhydantoins oder des 4,4'-Methylen-5,5'-tetramethyldihydantoins, oder solche wie Triglycidylisocyanurat.

Weitere Glycidylverbindungen mit technischer Bedeutung sind die Glycidylester von Carbonsäuren, insbesondere Di- und Polycarbonsäuren. Beispiele dafür sind die Glycidylester der Bernsteinsäure, Adipinsäure, Azelainsäure, Sebacinsäure, Phthalsäure, Terephthalsäure, Tetra- und Hexahydrophthalsäure, Isophthalsäure oder Trimellithsäure, oder von demerisierten Fettsäuren.

Beispiele für von Glycidylverbindungen verschiedene Polyepoxide sind die Diepoxide des Vinylcyclohexens und Dicyclopentadiens, 3-(3',4'-Epoxicyclohexyl)-8,9-epoxy-2,4-dioxaspiro[5.5]undecan, der 3',4'-Epoxicyclohexylmethylester der 3,4-Epoxicyclohexancarbonsäure, Butadiendiepoxid oder Isoprendiepoxid, epoxidierte Linolsäurederivate oder epoxidiertes Polybutadien.

Bevorzugte Epoxiharze sind gegebenenfalls vorverlängerte Diglycidyläther zweiwertiger Phenole oder zweiwertiger aliphatischer Alkohole mit 2 bis 4 Kohlenstoffatomen. Besonders bevorzugt werden die gegebenenfalls vorverlängerten Diglycidyläther des 2,2-Bis-(4-hydroxyphenyl)-propans und Bis-(4-hydroxyphenyl)-methans.

Als kationisch polymerisierbare Verbindungen kommen ferner in Betracht :

III. Methylolverbindungen :

1. Aminoplaste wie die N-Hydroxymethyl-, N-Methoxymethyl-, N-n-Butoxymethyl- und N-Acetoxymethylderivate von Amiden oder amidartigen Verbindungen, z. B. cyclischen Harnstoffen wie Aethylenharnstoff (Imidazolidin-2-on), Hydantoin, Uron (Tetrahydro-oxadiazin-4-on), 1,2-Propylenharnstoff (4-Methylimidazolidin-2-on), 1,3-Propylenharnstoff (Hexahydro-2H-pyrimid-2-on), Hydroxypropylenharnstoff (5-Hydroxyhexahydro-2H-pyrimid-2-on), 1,3,5-Melamin und weitere Polytriazine wie Acetoguanamin, Benzoguanamin und Adipoguanamin.

Gewünschtenfalls kann man Aminoplaste einsetzen, die sowohl N-Hydroxymethyl- als auch N-Alkoxymethyl- oder sowohl N-Hydroxymethyl- als auch N-Acetoxymethylgruppen enthalten (beispielsweise ein Hexamethylolmelamin, in dem 1 bis 3 der Hydroxylgruppen mit Methylgruppen veräthert sind).

Als Aminoplaste werden die Kondensationsprodukte von Harnstoff, Uron, Hydantoin oder Melamin mit Formaldehyd sowie teilweise oder völlig verätherte Produkte solcher Kondensationsprodukte mit einem aliphatischen einwertigen Alkohol mit 1 bis 4 Kohlenstoffatomen bevorzugt.

2. Phenoplaste.

Bevorzugte Phenoplaste sind aus einem Phenol und einem Aldehyd hergestellte Resole. Zu geeigneten Phenolen gehören Phenol selbst, Resorcin, 2,2-Bis-(p-hydroxyphenyl)-propan, p-Chlorphenol, ein durch eine oder zwei Alkylgruppen mit je 1 bis 9 Kohlenstoffatomen substituiertes Phenol, wie o-, m- und p-Kresol, die Xylenole, p-tert.-Butylphenol und p-Nonylphenol sowie auch phenylsubstituierte Phenole, insbesondere p-Phenylphenol. Der mit dem Phenol kondensierte Aldehyd ist vorzugsweise Formaldehyd, doch kommen auch andere Aldehyde wie Acetaldehyd und Furfurol in Frage. Gewünschtenfalls kann man ein Gemisch solcher härtbarer Phenol/Aldehydharze verwenden.

Die bevorzugten Resole sind Kondensationsprodukte des Phenols, p-Chlorphenols, Resorcins oder o-, m- oder p-Kresols mit Formaldehyd.

Die erfindungsgemässen härtbaren Zusammensetzungen lassen sich in beliebeiger Form erhalten, z. B. als homogene flüssige Gemische oder in homogener oder inhomogener glasiger Form. Homogene glasige Produkte können in an sich bekannter Weise zum Beispiel durch Verflüssigung fester polymerisierbarer organischer Materialien, gegebenenfalls unter Zusatz geeigneter Lösungsmittel im Dunkeln oder unter rotem Licht, Erhitzen auf Temperaturen über ihrem Glasübergangspunkt, Zugabe des Initiators der Formel I and Abkühlung der entstandenen Gemische erhalten werden. Gewünschtenfalls kann man die so erhaltenen glasigen Produkte anschliessend zerkleinern. Inhomogene glasige Produkte können beispielsweise durch Vermischen glasiger polymerisierbarer Materialien in Pulverform mit erfindungsgemässen Initiatoren erhalten werden.

Die erfindungsgemässen härtbaren Zusammensetzungen sind bei Raumtemperatur in verhältnismässiger Dunkelheit, z. B. in rotem Licht, beträchtliche Zeit lagerfähig. Je nach ihrer Zusammensetzung und ihrem Endzweck, z. B. zur Herstellung von Ueberzügen oder Filmen, können sie direkt heissgehärtet werden. Die Temperaturen zur direkten Heisshärtung liegen vorzugsweise nahe bei dem Schmelzpunkt des eingesetzten Initiators. Die Heisshärtung ist normalerweise nach etwa 3 bis 10 Minuten vollständig.

Besonders bevorzugt wird zweistufige Polymerisation (Härtung), indem man zunächst den Initiator der Formel I durch Bestrahlung der härtbaren Zusammensetzungen aktiviert und dann die so erhaltenen aktivierten Vorstufen heisshätet, wobei die Bestrahlungstemperatur unter der zum nachfolgenden

Heisshärten angewandten liegt. Diese aktivierten Vorstufen lassen sich normalerweise bei Temperaturen härten, die erheblich niedriger liegen als bei direktem Heisshärten erforderlich ist, vorteilhaft im Bereich von 50° bis 110 °C. Diese zweistufige Härtung ermöglicht es auch, die Polymerisation auf besonders einfache und vorteilhafte Weise zu steuern. Zudem sind die aus den glasigen erfindungsgemässen härtbaren Zusammensetzungen erhältlichen aktivierten Vorstufen bei Raumtemperatur sogar im Licht beträchtliche Zeit lagerfähig, im Gegensatz zu bekannten kationisch polymerisierbaren Zusammensetzungen des Standes der Technik, z. B. solchen, die Sulfonium- oder Jodoniumsalze als Initiatoren enthalten. Dieses Merkmal stellt einen weiteren wesentlichen Vorteil der zweistufigen Härtung und dieser aktivierten Vorstufen dar. Aus flüssigen erfindungsgemässen härtbaren Zusammensetzungen erhältliche aktivierte Vorstufen besitzen im allgemeinen im Licht nur begrenzte Lagerfähigkeit und werden zweckmässig direkt weiterverwendet.

Die Bestrahlung der härtbaren Gemische zur Herstellung der aktivierten Vorstufen erfolgt zweckmässig mit Elektronenstrahlen oder aktinischem Licht, vorzugsweise einer Wellenlänge von 200 bis 600 nm und einer Intensität von 150 bis 5 000 Watt. Als Lichtquellen eignen sich beispielsweise Xenonlampen, Argonlampen, Wolframlampen, Kohlelichtbögen, Metallhalogenid- und Metallichtbogenlampen, wie Niederdruck-, Mitteldruck- und Hochdruckquecksilberlampen. Vorzugsweise wird die Bestrahlung mit Metallhalogenid- oder Hochdruckquecksilberlampen durchgeführt. Die Bestrahlungszeit hängt von verschiedenen Faktoren ab, einschliesslich z. B. dem polymerisierbaren organischen Material, der Art der Lichtquelle und deren Abstand vom bestrahlten Material. Die Bestrahlungszeit beträgt vorzugsweise 10 bis 60 Sekunden.

Das Erhitzen der belichteten Zusammensetzungen kann in herkömmlichen Konvektionsöfen stattfinden. Sind kurze Erhitzungs- oder Reaktionszeiten erforderlich, so kann das Erhitzen durch Belichtung mit beispielsweise IR-Strahlung, IR-Lasern oder Mikrowellengeräten erfolgen.

Dementsprechend betrifft die Erfindung auch aktivierte härtbare Zusammensetzungen, die durch Bestrahlung härtbarer Zusammensetzungen, die ein kationisch polymerisierbares organisches Material A) und mindestens eine Verbindung der Formel I enthalten, bei einer Temperatur, die unter der zum nachfolgenden Heisshärten angewandten liegt, erhältlich sind. Das oben bezüglich der bevorzugten kationisch polymerisierbaren Materialien und verbindungen der Formel I Gesagte gilt auch hier.

Die härtbaren Zusammensetzungen und die daraus erhältlichen aktivierten Vorstufen können auch weitere, bekannte und üblicherweise in der Technik photopolymerisierbarer Materialien eingesetzte Zusatzstoffe enthalten. Beispiele für solche Zusatzstoffe sind Pigmente, Farbstoffe, Füllstoffe und Verstärkungsmittel, Glasfasern und sonstige Fasern, Flammhemmstoffe, Antistatika, Verlaufmittel, Antioxydantien und Lichtschutzmittel.

Zur Erhöhung der Lagerfähigkeit im Dunkeln können die härtbaren Zusammensetzungen und aktivierten Vorstufen schwache organische Basen wie Nitrile, Amide, Lactone oder Harnstoffderivate enthalten. Um vorzeitige Reaktion durch unbeabsichtigte Belichtung zu vermeiden, kann man kleine Mengen UV-Absorptionsmittel und/oder organische Farbstoffe zusetzen.

Ausserdem können die härtbare Zusammensetzung und die aktivierten Vorstufen mono- oder polyfunktionelle Verbindungen oder Harze enthalten, die nach einem Radikalmechanismus härten. Beispiele dafür sind Acrylat- und/oder Methacrylatester aliphatischer Polyole. Die Härtungsreaktion dieser Substanzen wird durch radikalbildende (Photo)-initiatoren oder Elektronenstrahlen eingeleitet. Hitzeaktivierbare Initiatoren sind beispielsweise Peroxyde oder Azoverbindungen. Beispiele für durch Belichtung aktivierte Initiatoren sind Acetophenone, Acylphosphinoxyde oder aromatische Ketone. Um die Endeigenschaften von Epoxidharzen zu verbessern, kann man polyfunktionelle Hydroxylverbindungen, zum Beispiel wie in der deutschen Offenlegungsschrift 26 39 395 beschrieben, einarbeiten.

Ein wesentlicher Vorteil der erfindungsgemässen härtbaren Zusammensetzungen und der daraus erhältlichen aktivierten Vorstufen besteht darin, dass sogar für kurze Härtungszeiten die Verwendung herkömmlicher Photosensibilisatoren entfallen kann.

Die erfindungsgemässen härtbaren Zusammensetzungen und die daraus erhältlichen aktivierten Vorstufen eignen sich beispielsweise zur Herstellung von Oberflächenbeschichtungen auf verschiedenen Substraten. Für diesen Anwendungsfall werden sie vorzugsweise in flüssiger Form eingesetzt. Geeignete Substrate sind beispielsweise Metalle, wie Stahl, Aluminium, Kupfer, Cadmium und Zink, Keramik, Glas, Kunststoffe, Papier oder Holz.

Wird bei der oben beschriebenen zweistufigen Polymerisation zunächst nur ein Teil der Beschichtung durch eine Maske hindurch bestrahlt, so können die unbelichteten Stellen nach einer anschliessenden kurzen Heisshärtung mit einem geeigneten Lösungsmittel entfernt werden. Die erfindungsgemässen härtbaren Zusammensetzungen sind somit zur Reproduktion von Abbildungen oder zur Herstellung von Druckplatten und insbesondere gedruckten Schaltungen (Photoresists) nach an sich bekannten Methoden (siehe z. B. britische Patentschrift 1 495 746) geeignet.

Die erfindungsgemässen Zusammensetzungen und die daraus erhältlichen aktivierten Vorstufen sind auch als Klebstoffe oder zur Herstellung von Kitten, Füllstoffen oder faserverstärkten Verbundstoffen und Schichtkörpern verwendbar. Auch ist es möglich, ein Epoxiharz oder ein Phenoplast als polymerisierbares Material enthaltende, erfindungsgemässe härtbare Zusammensetzungen in zwei Stufen zu härten.

Dabei geht man so vor, dass das Gemisch aus Initiator der Formel I und Epoxiharz oder Phenoplast

zunächst durch Bestrahlung in Gegenwart eines latenten, hitzeaktivierbaren Vernetzungsmittels für das Epoxiharz oder Phenoplast in die teilweise gehärtete B-Stufe umgewandelt wird. Die so erhaltene, teilweise gehärtete Zusammensetzung wird dann zum Aushärten in einer zweiten Stufe erhitzt. Vorzugsweise verwendet man ein Polycarbonsäureanhydrid als latentes, hitzeaktivierbares Vernetzungsmittel. Die erfindungsgemässen, Epoxiharze oder Phenoplaste enthaltenden härtbaren Zusammensetzungen eignen sich insbesondere zur Herstellung von gedruckten Schaltungen, Fadenwickeln, Formmassen oder Klebfilmen (siehe z. B. die bekanntgemachte europäische Patentanmeldung 44 274, in der solche bekannten Anwendungen näher beschrieben sind).

Für die obigen Anwendungen enthalten die erfindungsgemässen härtbaren Zusammensetzungen oder die daraus erhältlichen aktivierten Vorstufen zweckmässig 0,1 bis 15 Gew.-%, vorzugsweise 0,5 bis 5 Gew.-%, bezogen auf das polymerisierbare organische Material A), mindestens einer Verbindung der Formel I.

Von besonderem Interesse sind auch homogene, glasige, härtbare Zusammensetzungen und daraus erhältliche aktivierte Vorstufen, die bis äquimolare Mengen eines Initiators der Formel I und ein polymerisierbares organisches Material A) enthalten, wobei « äquimolar » so zu verstehen ist, dass es sich auf die reaktive Gruppe des polymerisierbaren organischen Materials bezieht. Solche Gemische sind als Härter für kationisch polymerisierbare Materialien der oben bezeichneten Art verwendbar, insbesondere Epoxiharze. Nichtaktivierte härtbare Gemische dieses Typs werden vorteilhaft direkt glasigen, kationisch polymerisierbaren Materialien zugesetzt und auf die obengenannte Weise heissgehärtet. Entsprechende aktivierte Vorstufen eignen sich als Härter für kationisch polymerisierbares Material, in der flüssigen oder festen (glasigen) Form.

Beispiel 1

Man rührt ein Gemisch aus 2 g Bis-($\eta^5$-indenyl)-eisen(II), 1,8 g Aluminiumchlorid, 0,18 g Aluminium und 50 ml Toluol 14 Stunden bei 100 °C. Das Gemisch wird auf Raumtemperatur abgekühlt und in 200 g Eiswasser gegossen, 30 Minuten gerührt und dann filtriert. Die wässrige, orangefarbige Phase wird abgetrennt und mit einer Lösung von 1,3 g $KPF_6$ in 100 ml Wasser vermischt. Die gebildeten Kristalle werden abfiltriert, zweimal mit 20 ml Wasser gewaschen und 14 Stunden bei 40 °C/13 000 Pa getrocknet, was 2,1 g (75 % der Theorie) ($\eta^6$-Toluol) ($\eta^5$-indenyl)-eisen(II)-hexafluorophosphat ergibt. Umkristallisieren aus Methylenchlorid/n-Hexan liefert 1,85 g (66 % der Theorie) des obengenannten Komplexes ; Schmelzpunkt 168-173 °C.

Beispiel 2

Man rührt ein Gemisch aus 8 g Ferrocen, 11,4 g Aluminiumchlorid, 1,12 g Aluminium, 10,3 g Pyren, 3 Tropfen Mesitylen und 50 ml einer Octanfraktion 14 Stunden lang bei 110 °C. Die Aufarbeitung erfolgt wie in Beispiel 1 beschrieben. Zu der wässrigen Phase gibt man 5,5 g des Natriumsalzes von $SbF_6$, isoliert die gebildeten Kristalle durch Filtrieren und trocknet 14 Stunden bei 40 °C/13 000 Pa, was 6,0 g (25 % der Theorie) ($\eta^6$-Pyren) ($\eta^5$-cyclopentadienyl)-eisen(II)-hexafluoroantimonat ergibt. Umkristallisieren aus Methylenchlorid/n-Hexan liefert 5,1 g (21,5 % der Theorie) des obengenannten Komplexes ; Schmelzpunkt 160-170 °C.

Beispiel 3

($\eta^6$-Toluol) ($\eta^5$-cyclopentadienyl)-eisen(II)-hexafluorophosphat, Schmelzpunkt 150-160 °C ; gemäss Bull. Soc. Chim. France, 2572 (1975) hergestellt.

Beispiel 4

($\eta^6$-Methoxybenzol) ($\eta^5$-cyclopentadienyl)-eisen(II)-hexafluorophosphat, Schmelzpunkt 125-136 °C ; gemäss Dokl. Akad. Nauk SSSR, *175*, 609 (1967) hergestellt.

Beispiel 5

($\eta^6$-p-Chlortoluol) ($\eta^5$-cyclopentadienyl)-eisen(II)-hexafluorophosphat, Schmelzpunkt 225-230 °C ; gemäss J. Organomet. Chem. *20*, 169 (1969) hergestellt.

Beispiel 6

($\eta^6$-Naphthalin) ($\eta^5$-cyclopentadienyl)-eisen(II)-hexafluorophosphat, Schmelzpunkt 160-168 °C ; gemäss J. Organomet. Chem., *101*, 221 (1975) hergestellt.

Beispiel 7

($\eta^6$-Naphthalin) ($\eta^5$-cyclopentadienyl)-eisen(II)-tetrafluoroborat ; Schmelzpunkt 126-131 °C ; gemäss Izv. Akad. Nauk SSSR, Ser. Khim., *8*, 1472 (1966) hergestellt.

Beispiel 8

($\eta^6$-Naphthalin) ($\eta^5$-cyclopentadienyl)-eisen(II)-hexafluoroantimonat ; aus der Verbindung nach Beispiel 7 durch Auflösen von 2 g ($\eta^6$-Naphthalin) ($\eta^5$-cyclopentadienyl)-eisen(II)-tetrafluoroborat in 100 ml Wasser/Methanol (2 : 1) und Zusatz von 1,5 g $NaSbF_6$ hergestellt. Die braunen Kristalle werden isoliert und 16 Stunden bei 40 °C/13 000 Pa getrocknet ; Schmelzpunkt 151-157 °C.

Beispiel 9

($\eta^6$-Naphthalin) ($\eta^5$-cyclopentadienyl)-eisen(II)-hexafluoroarsenat ; aus der Verbindung nach Beispiel 7 durch Auflösen von 2 g ($\eta^6$-Naphthalin) ($\eta^5$-cyclopentadienyl)-eisen(II)-tetrafluoroborat in 100 ml Wasser/Methanol (2 : 1) und Zusatz von 1,4 g $KAsF_6$ hergestellt. Die braunen Kristalle werden isoliert und 16 Stunden bei 40 °C/13 000 Pa getrocknet ; Schmelzpunkt 149-158 °C.

Beispiel 10

($\eta^6$-Chlornaphthalin) ($\eta^5$-cyclopentadienyl)-eisen(II)-hexafluorophosphat, Schmelzpunkt 147-151 °C ; gemäss J. Organomet. Chem., *101*, 221 (1975) hergestellt.

Beispiel 11

($\eta^6$-2-Methoxynaphthalin) ($\eta^5$-cyclopentadienyl)-eisen(II)-hexafluorophosphat.

Man erhitzt ein Gemisch aus 4 g Ferrocen, 5,7 g Aluminiumchlorid, 0,56 g Aluminium und 50 g 2-Methoxynaphthalin 16 Stunden lang auf 110 °C, kühlt ab, giesst dann in 200 g Eiswasser, rührt eine halbe Stunde und filtriert. Dann versetzt man das Filtrat mit 3,9 g Kaliumhexafluorophosphat. Die orangefarbigen Kristalle werden isoliert und 16 Stunden bei 40 °C/13 000 Pa getrocknet ; Schmelzpunkt 123-130 °C.

Beispiel 12

($\eta^6$-Biphenyl) ($\eta^5$-cyclopentadienyl)-eisen(II)-hexafluorophosphat ; Schmelzpunkt 135-140 °C, gemäss. C.R. Acad. Sc. Ser. C., *272*, 1337 (1971) hergestellt.

Beispiel 13

($\eta^6$-Diphenylensulfid) ($\eta^5$-cyclopentadienyl)-eisen(II)-hexafluorophosphat wird auf analoge Weise wie in Beispiel 11 beschrieben aus 4 g Ferrocen, 5,7 g Aluminiumchlorid, 0,56 g Aluminium, 50 g Diphenylensulfid und 3,5 g Ammoniumhexafluorophosphat hergestellt ; Schmelzpunkt 166-170 °C.

Beispiel 14

($\eta^6$-Pyren) ($\eta^5$-cyclopentadienyl)-eisen(II)-hexafluorophosphat wird auf analoge Weise wie in Beispiel 11 aus 4 g Ferrocen, 5,7 g Aluminiumchlorid, 0,56 g Aluminium, 50 g Pyren und 3,5 g Ammoniumhexafluorophosphat hergestellt ; Schmelzpunkt 169-175 °C.

Beispiel 15

Man rührt ein Gemisch aus 1,3 g Ferrocen, 1,8 g Aluminiumchlorid, 1,7 g Perylen und 30 ml einer Octanfraktion 4 Stunden bei 100 °C. Die Aufarbeitung erfolgt wie in Beispiel 1 beschrieben. Zu der wässrigen Phase gibt man 0,9 g Natriumsulfit und 1,2 g $KPF_6$, isoliert die gebildeten Kristalle durch Filtrieren und trocknet 14 Stunden bei 40 °C/13 000 Pa, was 0,4 g (11 % der Theorie) ($\eta^6$-Perylen) ($\eta^5$-cyclopentadienyl)-eisen(II)-hexafluorophosphat ergibt.

Beispiel 16

($\eta^6$-Mesitylen) ($\eta^5$-acetylcyclopentadienyl)-eisen(II)-hexafluorophosphat ; Schmelzpunkt 150-158 °C, nach der in Dokl. Akad. Nauk SSSR *160*, 1327 (1965) beschriebenen Methode hergestellt, jedoch unter Verwendung von Kaliumhexafluorophosphat.

Beispiel 17

($\eta^6$-Inden) ($\eta^5$-indenyl)-eisen(II)-hexafluorophosphat.

Man erhitzt ein Gemisch aus 2 g Bis-($\eta^5$-indenyl)-eisen(II), 1,8 g Aluminiumchlorid, 0,18 g Aluminium

und 50 ml einer Octanfraktion 4 Stunden auf 80 °C. Nach dem Abkülen giesst man in 100 g Eiswasser, rührt 30 Minuten und filtriert. Das Filtrat wird in einem Scheidetrichter von der organischen Phase abgetrennt. Zu der wässrigen roten Lösung gibt man 1,3 g Kaliumhexafluorophosphat, isoliert die dunkelroten Kristalle und trocknet 16 Stunden bei Raumtemperatur/13 000 Pa ; Schmelzpunkt 120-130 °C.

Beispiel 18

Bis-($\eta^6$-Mesitylen)-eisen(II)-bis-(hexafluorophosphat) ; Schmelzpunkt > 250 °C ; gemäss J. Chem. Soc., Chem. Comm., 930 (1971) hergestellt.

Beispiel 19

Bis-($\eta^6$-1-methylnaphthalin)-eisen(II)-bis-hexafluorophosphat).

Man erhitzt ein Gemisch aus 9,72 g Eisen(III)-chlorid, 16 g Aluminiumchlorid und 50 ml 1-Methylnaphthalin 3,5 Stunden auf 95 °C. Man kühlt ab und giesst dann in 200 g Eis/Methanol (1 : 1), rührt 30 Minuten und trennt die organische Phase in einem Scheidetrichter ab. Zu der wässrig-methanolischen Phase gibt man 22 g Kaliumhexafluorophosphat, isoliert die roten Kristalle und trocknet 24 Stunden bei Raumtemperatur/13 000 Pa ; Schmelzpunkt 84-99 °C.

Beispiel 20

($\eta^6$-Benzol) ($\eta^5$-cyclopentadienyl)-kobalt(III)-bis-(tetrafluoroborat) ; Schmelzpunkt > 250 °C, gemäss Z. Naturforsch., *16*b, 556 (1961) hergestellt.

Beispiel 21

($\eta^6$-Benzol) ($\eta^5$-cyclopentadienyl)-kobalt(III)-bis-(hexafluorophosphat) ; Schmelzpunkt 163-173 °C, gemäss Z. Naturforsch., *16*b, 556 (1961) hergestellt.

Beispiel 22

Man löst ein Vorkondensat aus 38,56 Gewichtsteilen mit Epichlorhydrin umgesetztem Bisphenol A und 10,82 Gewichsteilen Bisphenol A mit einem Gesamtepoxidgehalt von 2,17-2,44 val/kg in 14,81 Gewichsteilen Aceton und 34,57 Gewichsteilen Methyläthylketon. Zu dieser Lösung gibt man 1,24 Gewichsteile ($\eta^6$-Naphthalin) ($\eta^5$-cyclopentadienyl)-eisen(II)-hexafluorophosphat. Die homogene Lösung wird mit einer 24 $\mu$-Rakel auf eine kupferkaschierte Epoxidplatte aufgebracht (Nassfilmdicke 24 $\mu$). Der Film wird 20 Minuten bei 75 °C getrocknet und dann 3 Minuten bei 20 °C mit einer 5 000 W Metallhalogenidlampe bestrahlt. Eine Stouffer-21-Stufen-Grauskala wird dabei als Photomaske verwendet. Die Platte wird dann 3 Minuten bei 80 °C gehärtet und in Methyläthylketon entwickelt. Aetzen in 50 %iger $FeCl_3$-Lösung liefert ein Stufenbild Nr. 7.

Beispiele 23-42

Weiterekupferkaschierte Epoxidplatten werden auf analoge Weise wie in Beispiel 22 beschrieben unter Verwendung verschiedener Initiatoren der Formel I beschichtet und bestrahlt. Die übrigen Reaktionsbedingungen und die Ergebnisse sind in der nachfolgenden Tabelle 1 angeführt.

(Siehe Tabelle 1 Seite 10 ff.)

Beispiel 43

Zwei 150 × 25 × 1,5 mm grosse Anticorodal-100-B-Prüfstreifen werden jeweils an einem Ende aufgerauht, gereinigt und entfettet. Die aufgerauhten und entfetteten Enden der Prüfstreifen werden auf einer Seite mit je etwa 0,3 g eines sich von Bisphenol A abelitenden oligomeren Diglycidyläthers (Epoxydgehalt 5,1-5,5 val/kg), der 2,5 Gew.-% des Komplexes nach Beispiel 6 enthält, so beschichtet, dass man einen Film von 100-300 $\mu$m Dicke erhält. Diese Beschichtungen werden dann 16,8 Sekunden mit einem PPG-Bestrahlungsapparat mit 2 Lampen (80 W/cm) bestrahlt. Die belichteten Flächen werden dann so übereinandergelegt, dass sich die Proben 12 mm überlappen. Die Beiden Streifen werden dann sorgfältig eingeklammert und 30 Minuten bei 120 °C gehärtet. Dann kühlt man sie im Verlauf von 30 Minuten auf Raumtemperatur ab und entfernt die Klammern. Die Scherfestigkeit wird mittels einer Zerreissmaschine mit einem Vorschub von 5 mm/Minute bis zum Bruch der Verklebung gemessen. Die Verklebung besitzt eine Scherfestigkeit von 13 $N/mm^2$.

Tabelle 1

| Bsp. | Initiator | | | Härtungszeit Minuten | Härtungstemperatur °C | Letzte abgebildete Keilstufe auf einer Stouffer-21-Stufen-Grauskala | | |
|---|---|---|---|---|---|---|---|---|
| | nach Bsp. | Gew.-% | Mol-% (auf 100 g Harz) | | | Bestrahlungszeit 1 Minute | 3 Minuten | 12 Minuten |
| 23 | 3 | 2,6 | $7,26 \times 10^{-3}$ | 3 | 80 | 4 | 6 | - |
| 24 | 4 | 2,6 | $6,94 \times 10^{-3}$ | 3 | 80 | 5 | 8 | - |
| 25 | 5 | 2,5 | $6,37 \times 10^{-3}$ | 3 | 100 | - | 5 | - |
| 26 | 6 | 2,5 | $6,34 \times 10^{-3}$ | 3 | 100 | - | 8 | - |
| 27 | 9 | 2,5 | $5,69 \times 10^{-3}$ | 3 | 100 | - | 10 | - |
| 28 | 8 | 2,5 | $5,14 \times 10^{-3}$ | 3 | 80 | - | 8 | - |
| 29 | 7 | 2,5 | $7,44 \times 10^{-3}$ | 3 | 70 | - | 3 | - |
| 30 | 7 | 2,5 | $7,44 \times 10^{-3}$ | 3 | 100 | - | 8 | - |
| 31 | 10 | 2,5 | $5,83 \times 10^{-3}$ | 3 | 120 | - | 11 | - |
| 32 | 11 | 2,6 | $5,92 \times 10^{-3}$ | 3 | 80 | 8 | 11 | - |
| 33 | 12 | 2,6 | $6,18 \times 10^{-3}$ | 3 | 80 | 5 | 8 | - |
| 34 | 13 | 2,6 | $5,77 \times 10^{-3}$ | 3 | 80 | 8 | 12 | - |
| 35 | 14 | 2,6 | $5,55 \times 10^{-3}$ | 3 | 80 | 10 | 16 | - |
| 36 | 15 | 2,5 | $4,82 \times 10^{-3}$ | 3 | 100 | 16 | - | - |
| 37 | 2 | 2,5 | $3,78 \times 10^{-3}$ | 3 | 100 | - | 13 | - |
| 38 | 16 | 2,5 | $5,83 \times 10^{-3}$ | 3 | 100 | - | 1 | 5 |
| 39 | 1 | 2,6 | $6,37 \times 10^{-3}$ | 3 | 100 | 0 | 3 | - |

Tabelle 1 (Fortsetzung)

| Bsp. | Initiator | | | Härtungszeit Minuten | Härtungstemperatur °C | Letzte abgebildete Keilstufe auf einer Stouffer-21-Stufen-Grauskala | | |
|---|---|---|---|---|---|---|---|---|
| | nach Bsp. | Gew.-% | Mol-% | | | Bestrahlungszeit | | |
| | | (auf 100 g Harz) | | | | 1 Minute | 3 Minuten | 12 Minuten |
| 40 | 17 | 2,5 | $5,77 \times 10^{-3}$ | 3 | 100 | - | 0 | 2 |
| 41 | 18 | 2,5 | $4,26 \times 10^{-3}$ | 3 | 100 | 1 | - | 5 |
| 42 | 19 | 2,5 | $3,68 \times 10^{-3}$ | 3 | 75 | 0 | 5 | 9 |

Beispiel 44

Man löst ein Vorkondensat aus 38,56 Gewichtsteilen mit Epichlorhydrin umgesetztem Bisphenol A und 10,82 Gewichtsteilen Bisphenol A mit einem Gesamtepoxidgehalt von 2,17-2,44 val/kg in 14,81 Gewichtsteilen Aceton und 34,57 Gewichtsteilen Methyläthylketon. Zu dieser Lösung gibt man 1,24 Gewichtsteile ($\eta^6$-Naphthalin) ($\eta^5$-cyclopentadienyl)-eisen(II)-hexafluorophosphat. Die homogene Lösung wird mit einer 24 µm-Rakel auf eine Kupferkaschierte Epoxidplatte aufgebracht (Nassfilmdicke 24 µm). Der Film wird 20 Minuten bei 75 °C getrocknet und dann 3 Minuten bei 20 °C mit einer 5 000 W Metallhalogenidlampe bestrahlt. Eine Stouffer-21-Stufen-Grauskala wird dabei als Photomaske verwendet. Nach der Belichtung wird die Platte 4 Monate bei Raumtemperatur in völliger Dunkelheit gelagert. Danach wird sie 3 Stunden bei 100 °C gehärtet und in Methyläthylketon entwickelt. Aetzen in 50 %iger $FeCl_3$-Lösung liefert ein Stufenbild Nr. 7.

Beispiel 45

Zwei 150 × 25 × 1,5 mm grosse Anticorodal-100-B-Prüfstreifen werden jeweils an einem Ende aufgerauht und entfettet. Die aufgerauhten und entfetteten Enden der Prüfstreifen werden jeweils auf einer Seite mit einem homogenen Gemisch eines Vorkondensats aus 38,56 Gewichtsteilen mit Epichlorhydrin umgesetztem Bisphenol A und 10,82 Gewichtsteilen Bisphenol A mit einem Gesamtepoxidgehalt von 2,41 val/kg, mit 14,81 Gewichtsteilen Aceton, 34,57 Gewichtsteilen Methyläthylketon und 1,24 Gewichtsteilen ($\eta^6$-Naphthalin) ($\eta^5$-cyclopentadienyl)-eisen(II)-hexafluorophosphat als Initiator beschichtet. Die behandelten Prüfstreifen werden dann 120 Minuten bei 75 °C unter Bildung eines nichtklebrigen Films an den beschichteten Enden getrocknet. Dann bestrahlt man die beschichteten Streifen 3 Minuten mit einer 5 000 W Metallhalogenidlampe. Die belichteten Flächen werden dann so übereinandergelegt, dass sich die Proben 12 mm überlappen. Die beiden Streifen werden dann sorgfältig eingeklammert und 40 Minuten bei 100 °C gehärtet. Dann kühlt man sie auf Raumtemperatur ab und entfernt die Klammern. Die Scherfestigkeit wird mittels einer Zerreissmaschine mit einem Vorschub von 5 mm/Minute bis zum Bruch der Verklebung gemessen. Die Verklebung besitzt eine Scherfestigkeit von 11,8 $N/mm^2$.

Beispiel 46

Zwei 150 × 25 × 1,5 mm grosse Anticorodal-100-B-Prüfstreifen werden jeweils an einem Ende aufgerauht und entfettet. Die aufgerauhten und entfetteten Enden der Prüfstreifen werden jeweil auf einer Seite mit einem homogenen Gemisch eines Vorkondensats aus 38,56 Gewichtsteilen mit Epichlorhydrin umgesetztem Bisphenol A und 10,82 Gewichtsteilen Bisphenol A mit einem Gesamtepoxidgehalt von 2,41 val/kg, mit 14,81 Gewichtsteilen Aceton, 34,57 Gewichtsteilen Methyläthylketon und 1,24 Gewichtsteilen ($\eta^6$-Naphthalin) ($\eta^5$-cyclopentadienyl)-eisen(II)-hexafluorophosphat als Initiator beschichtet. Die behandelten Prüfstreifen werden dann 120 Minuten bei 75 °C unter Bildung eines nichtklebrigen Films an den beschichteten Enden getrocknet. Die beschichteten Flächen werden dann so übereinandergelegt, dass sich die Proben 12 mm überlappen. Die beiden Streifen werden dann sorgfältig eingeklammert und 40 Minuten bei 160 °C gehärtet. Dann kühlt man sie auf Raumtemperatur ab und entfernt die Klammern. Die Scherfestigkeit wird mittels einer Zerreissmaschine mit einem Vorschub von 5 mm/Minute bis zum Bruch der Verklebung gemessen. Die Verklebung besitzt eine Scherfestigkeit von 10,9 $N/mm^2$.

Beispiel 47

Zwei 150 × 25 × 1,5 mm grosse Anticorodal-100-B-Prüfstreifen werden jeweils an einem Ende aufgerauht und entfettet. Die aufgerauhten und entfetteten Enden der Prüfstreiten werden jeweils auf einer Seite mit einem pulverförmigen Gemisch eines Vorkondensats aus 38,56 Gewichtsteilen mit Epichlorhydrin umgesetztem Bisphenol A und 10,82 Gewichtsteilen Bisphenol A mit einem Gesamtepoxidgehalt von 2,41 val/kg, mit 1,24 Gewichtsteilen ($\eta^6$-Naphthalin) ($\eta^5$-cyclopentadienyl)-eisen(II)-hexafluorophosphat als Initiator beschichtet. Die beschichteten Streifen werden dann 3 Minuten mit einer 5 000 W Metallhalogenidlampe bestrahlt. Die beschichteten Flächen werden dann so übereinandergelegt, dass sich die Proben 12 mm überlappen. Die beiden Streifen werden dann sorgfältig eingeklammert und 40 Minuten bei 100 °C gehärtet. Dann kühlt man sie auf Raumtemperatur ab und entfernt die Klammern. Die Scherfestigkeit wird mittels einer Zerreissmaschine mit einem Vorschub von 5 mm/Minute bis zum Bruch der Verklebung gemessen. Die Verklebung besitzt eine Scherfestigkeit von 8,32 $N/mm^2$.

Beispiele 48-51

Die folgenden Zusammensetzungen werden durch Vermischen der Komponenten miteinander und Auflösne der Zusatzstoffe im Epoxidharz erhalten :

Beispiel 48 :

100 g flüssiges Bisphenol A/Epoxidharz (Epoxidgehalt 5,5-7,5 val/kg, Viskosität 9 000-12 000 mPa · s bei 25 °C)

X g ($\eta^6$-Naphthalin) ($\eta^5$-cyclopentadienyl)-eisen(II)-hexafluorophosphat (A)

Beispiel 49 :

100 g flüssiges Epoxidharz aus epoxidierten Cycloolefinen (Epoxidgehalt 7,0-7,5 val/kg, Viskosität 4 500-5 200 mPa · s bei 25 °C) (B)

X g A

Beispiel 50 :

65 g flüssiges Epoxidharz B
35 g Hexandioldiacrylat
X g A
1 g Methyläthylketonperoxyd

Beispiel 51 :

65 g flüssiges Epoxidharz B
35 g Hexandioldiacrylat
X g A
2 g (2,4,6-Trimethylbenzoyl)-diphenylphosphinoxyd

Die Zusammensetzungen werden auf Glasplatten vergossen. Die Dicke der Filme beträgt etwa 60 µm. Die beschichteten Platten werden 4,2 Sekunden bei 20 °C unter Verwendung einer Quecksilberlampe mit 80 W/cm Lichtintensität bestrahlt. Direkt nach diesem Vorgang werden die Beschichtungen mit Infrarot (Quarzlampe, Typ MMS 2000 von Heraeus) so bestrahlt, dass die Temperatur der Filme nach 60 Sekunden 96 °C und nach 75 Sekunden 103 °C beträgt. Die Proben werden 0,5 Stunden bzw. 24 Stunden bei Raumtemperatur gelagert. Danach bestimmt man die Härte der Filme gemäss DIN 53 157. Die Ergebnisse sind in Tabelle 2 angeführt.

Tabelle 2

| Beispiel | Verbindung A (Gew.-%) | Härte (DIN 53 157) in Sekunden nach 60 Sekunden | | 75 Sekunden | |
|---|---|---|---|---|---|
| | | 0,5 h | 24 h | 0,5 h | 24 h |
| 48 | 0 | nass | nass | nass | nass |
| | 1,0 | 38 | 55 | 40 | 55 |
| | 2,0 | 140 | 155 | 168 | 186 |
| | 5,0 | 196 | 205 | 210 | 220 |
| 49 | 0 | nass | nass | nass | nass |
| | 1,0 | ~5 | ~5 | 14 | 14 |
| | 2,5 | ~5 | ~5 | 20 | 20 |
| | 5,0 | 18 | 21 | 34 | 34 |
| 50 | 0 | nass | nass | nass | nass |
| | 0,5 | nass | nass | nass | nass |
| | 1,0 | 39 | 80 | 62 | 81 |
| | 2,0 | 14 | 19 | 24 | 28 |
| 51 | 2,0 | klebt | 10 | klebt | 25 |

**Patentansprüche**

1. Härtbare Zusammensetzungen enthaltend
A) ein kationisch polymerisierbares organisches Material und
B) mindestens eine Verbindung der Formel I

$$[(R^1)\ (R^2\ M)_a]^{+an}\ \frac{an}{q}\ [LQ_m]^{-q} \qquad (I)$$

worin a 1 oder 2 sowie n und q unabhängig voneinander je eine ganze Zahl von 1 bis 3 sind, M das Kation eines einwertigen bis dreiwertigen Metalls aus Gruppe IVb bis VIIb, VIII oder Ib des Periodensystems darstellt, m eine der Wertigkeit von L + q entsprechende ganze Zahl ist und Q ein Halogenatom, L ein zweiwertiges bis siebenwertiges Metall oder Nichtmetall, $R^1$ ein $\pi$-Aren und $R^2$ ein $\pi$-Aren oder das Anion eines $\pi$-Arens bedeuten.

2. Zusammensetzungen nach Anspruch 1, dadurch gekennzeichnet, dass $R^1$ und/oder $R^2$ aromatische Gruppen mit 6 bis 24 Kohlenstoffatomen oder heteroaromatische Gruppen mit 3 bis 20 Kohlenstoffatomen darstellen, wobei diese Gruppen gegebenenfalls durch gleiche oder verschiedene Halogenatome, $C_{1-8}$-Alkyl-, $C_{1-8}$-Alkoxy-, Cyan-, $C_{1-8}$-Alkylthio-, $C_{2-6}$-Monocarbonsäureester-, Phenyl-, $C_{2-5}$-Alkanoyl- oder Benzoyl-gruppen einfach oder mehrfach substituiert sind.

3. Zusammensetzungen nach Anspruch 1, dadurch gekennzeichnet, dass $R^2$ das Anion eines aromatischen $\pi$-Arens mit 6 bis 24 Kohlenstoffatomen oder heteroaromatischen $\pi$-Arens mit 3 bis 20 Kohlenstoffatomen darstellt, welches jeweils gegebenenfalls durch gleiche oder verschiedene $C_{1-8}$-Alkyl-, $C_{2-6}$-Monocarbonsäureester-, Cyan-, $C_{2-5}$-Alkanoyl- oder Benzoylgruppen einfach oder mehrfach substituiert ist.

4. Zusammensetzungen nach Anspruch 1, dadurch gekennzeichnet, dass a 2 ist und $R^2$ je das Anion eines $\pi$-Arens und M je das gleiche Metallatom bedeuten.

5. Zusammensetzungen nach Anspruch 1, dadurch gekennzeichnet, dass a 1 ist sowie $R^1$ für Benzol, Toluol, Xylol, Methoxybenzol, Chlorbenzol, p-Chlortoluol, Naphthalin, Methylnaphthalin, Chlornaphthalin, Methoxynaphthalin, Biphenyl, Inden, Pyren oder Diphenylensulfid und $R^2$ für das Anion des Cyclopentadiens, Acetylcyclopentadiens oder Indens oder für Benzol, Toluol, Xylol, Trimethylbenzol, Naphthalin oder Methylnaphthalin stehen.

6. Zusammensetzungen nach Anspruch 1, dadurch gekennzeichnet, dass a 1 ist, $R^1$ $\eta^6$-Pyren oder $\eta^6$-Naphthalin und $R^2$ das Anion des $\eta^5$-Cyclopentadiens darstellen sowie n 1 oder 2 und q 1 sind.

7. Zusammensetzungen nach Anspruch 1, dadurch gekennzeichnet, dass als M ein Chrom-, Kobalt-, Mangan-, Wolfram-, Molybdän- oder Eisenkation und als $[LQ_m]^{-q}$ $SbF_6^-$, $BF_4^-$, $AsF_6^-$ oder $PF_6^-$ vorliegen.

8. Zusammensetzungen nach Anspruch 1, dadurch gekennzeichnet, dass als kationisch polymerisierbares organisches Material ein Epoxiharz vorliegt.

9. Zusammensetzungen nach Anspruch 1, dadurch gekennzeichnet, dass als kationisch polymerisierbares organisches Material ein gegebenenfalls vorverlängerter Diglycidyläther eines zweiwertigen Phenols oder eines zweiwertigen aliphatischen Alkohols mit 2 bis 4 Kohlenstoffatomen vorliegt.

10. Aktivierte härtbare Zusammensetzungen, erhältlich durch Bestrahlung einer härtbaren Zusammensetzung nach Anspruch 1, bei einer Temperatur, die unter der zum nachfolgenden Heisshärten angewandten liegt.

11. Zusammensetzungen nach Anspruch 1 oder 10, dadurch gekennzeichnet, dass sie 0,1 bis 15 Gew.-%, vorzugsweise 0,5 bis 5 Gew.-%, bezogen auf das polymerisierbare organische Material A), mindestens einer Verbindung der Formel I enthalten.

12. Zusammensetzungen nach Anspruch 1 oder 10, dadurch gekennzeichnet, dass sie bis äquimolare Mengen eines Initiators der Formel I und eines polymerisierbaren organischen Materials A) enthalten, wobei sich äquimolar auf die reaktive Gruppe dieses polymerisierbaren organischen Materials bezieht.

13. Verbindungen ausgewählt aus der Gruppe bestehend aus ($\eta^6$-Toluol) ($\eta^5$-indenyl)-eisen-(II)-hexafluorophosphat, ($\eta^6$-Pyren)($\eta^5$-cyclopentadienyl)-eisen-(II)-hexafluoroantimonat, ($\eta^6$-Naphthalin)($\eta^5$-cyclopentadienyl)-eisen-(II)-hexafluoroantimonat, ($\eta^6$-Naphthalin) ($\eta^5$-cyclopentadienyl)-eisen)-(II)-hexafluoroarsenat, ($\eta^6$-2-Methoxynaphthalin) ($\eta^5$-cyclopentadienyl)-eisen-(II)-hexafluorophosphat, ($\eta^6$-Diphenylensulfid) ($\eta^5$-cyclopentadienyl)-eisen(II)-hexafluorophosphat, ($\eta^6$-Perylen) ($\eta^5$-cyclopentadienyl)-eisen-(II)-hexafluorophosphat und Bis-$\eta^6$-1-methylnaphthalin)-eisen-(II)-hexafluorophosphat.

14. Verfahren zur Herstellung von Verbindungen der Formel Ia

$$[R^1 FeR^{2'}]_q^{\oplus} [LQ_m]^{q\ominus} \qquad (Ia)$$

worin $R^1$, L, Q, m und q die in Anspruch 1 definierte Bedeutung besitzen und $R^{2'}$ ein Anion eines $\pi$-Arens darstellt, durch Umsetzung eines ungeladenen $\pi$-Komplexes der Formel IIIa

$$[(R^{2'})_2 Fe] \qquad (IIIa)$$

mit einem $\pi$-Aren $R^1$ in Gegenwart von Aluminium und einer Lewissäure und nachfolgender Behandlung mit einem Slaz des Anions $[LQ_m]^{q-}$, dadurch gekennzeichnet, dass als Lewissäure $TiCl_4$ eingesetzt wird.

15. Beschichtetes Material, dadurch gekennzeichnet, dass es auf einem Substrat eine Beschrichtung aus Zusammensetzungen nach Anspruch 1 oder 10 enthält.

16. Verwendung von härtbaren Zusammensetzungen nach Anspruch 1 oder 10 zur Herstellung gehärteter Produkte, dadurch gekennzeichnet, dass man diese Zusammensetzungen direkt heisshärtet.

17. Verwendung von härtbaren Zusammensetzungen nach Anspruch 1 zur Herstellung gehärteter Produkte, dadurch gekennzeichnet, dass man zunächst den Initiator der Formel I durch Bestrahlung aktiviert und dann die so erhaltene aktivierte Vorstufe heisshärtet, derart, dass die Bestrahlungstemperatur unter dert zum nachfolgenden Heisshärten angewandten liegt.

18. Verwendung von härtbaren Zusammensetzungen nach Anspruch 12 als Härter für kationisch polymerisierbare organische Materialien.

**Claims**

1. A curable composition which comprises
   A) a cationically polymerisable organic material and
   B) at least one compound of the formula I

$$[(R^1)(R^2 M)_a]^{+an} \frac{an}{q} [LQ_m]^{-q} \qquad (I)$$

wherein a is 1 or 2, each of n and q independently of the other is an integer from 1 to 3, M is the cation of a monovalent to trivalent metal of groups IVb to VIIb, VIII or Ib of the Periodic Table, m is an integer corresponding to the valency of L + q, Q is a halogen atom, L is a divalent to heptavalent metal or non-metal, $R^1$ is a $\pi$-arene and $R^2$ is a $\pi$-arene or the anion of a $\pi$-arene.

2. A composition as claimed in claim 1, wherein $R^1$ and/or $R^2$ are aromatic groups having 6 to 24 carbon atoms or heteroaromatic groups having 3 to 20 carbon atoms, which groups are unsubstituted or mono- or polysubstituted by identical or different halogen atoms, $C_{1-8}$alkyl, $C_{1-9}$alkoxy, cyano, $C_{1-8}$ alkylthio, $C_{2-6}$monocarboxylic acid ester, phenyl, $C_{2-5}$alkanoyl or benzoyl groups.

3. A composition as claimed in claim 1, wherein $R^2$ is the anion of an aromatic $\pi$-arene containing 6 to 24 carbon atoms or a heteroaroamtic $\pi$-arene having 3 to 20 carbon atoms, each of which is unsubstituted or mono- or polysubstituted by identical or different $C_{1-8}$alkyl, $C_{2-6}$monocarboxylic acid ester, cyano, $C_{2-5}$alkanoyl or benzoyl groups.

4. A composition as claimed in claim 1, wherein a is 2, each $R^2$ is an anion of a $\pi$-arene and each M is an identical metal atom.

5. A composition as claimed in claim 1, wherein a is 1, $R^1$ is benzene, toluene, xylene, methoxybenzene, chlorobenzene, p-chlorotoluene, naphthalene, methylnaphthalene, chloronaphthalene, methoxynaphthalene, biphenyl, indene, pyrene or diphenylene sulfide, and $R^2$ is the anion of cyclopentadiene, acetylcyclopentadiene or indene, or is benzene, toluene, xylene, trimethylbenzene, naphthalene or methylnaphthalene.

6. A composition as claimed in claim 1, wherein a is 1, $R^1$ is $\eta^6$-pyrene or $\eta^6$-naphthalene, and $R^2$ is the anion of $\eta^5$-cyclopentadiene, n is 1 or 2, and q is 1.

7. A composition as claimed in claim 1, wherein M is a chromium, cobalt, manganese, tungsten, molybdenum or an iron cation, and $[LQ_m]^{-q}$ is $SbF_6^-$, $BF_4^-$, $AsF_6^-$ or $PF_6^-$.

8. A composition as claimed 1, wherein the cationically polymerisable organic material is an epoxy resin.

9. A composition as claimed in claim 1, wherein the cationically polymerisable organic material is a diglycidyl ether, which may have been advanced, of a divalent phenol or of a divalent aliphatic alcohol containing 2 to 4 carbon atoms.

10. An activated curable composition which is obtainable by irradiating a curable composition as claimed in claim 1 at a temperature which is below that employed for the subsequent heat-curing.

11. A composition as claimed in either claim 1 or claim 10, which comprises 0.1 to 15 % by weight, preferably 0.5 to 5 % by weight, based on the polymerisable organic material A), of at least one compound of the formula I.

12. A composition as claimed in either claim 1 or claim 10, which contains up to equimolar amounts of an initiator of the formula I and a polymerisable organic material A), equimolar referring to the reactive group of said polymerisable organic material.

13. A compound selected from the group consisting of ($\eta^6$-toluene) ($\eta^5$-indenyl) iron(II) hexafluorophosphate, ($\eta^6$-pyrene) ($\eta^5$-cyclopentadienyl) iron(II) hexafluoroantimonate, ($\eta^6$-naphthalene) ($\eta^5$-cyclopentadienyl) iron(II) hexafluoroantimonate, ($\eta^6$-naphthalene) ($\eta^5$-cyclopentadienyl) iron(II) hexafluoroarsenate, ($\eta^6$-2-methoxynaphthalene) ($\eta^5$-cyclopentadienyl) iron(II) hexafluorophosphate, ($\eta^6$-diphenylene sulfide) ($\eta^5$-cyclopentadienyl) iron(II) hexafluorophosphate, ($\eta^6$-perylene) ($\eta^5$-cyclopentadienyl) iron(II) hexafluorophosphate and bis($\eta^6$-1-methylnaphthalene) iron(II) hexafluorophosphate.

14. A process for the preparation of a compound of the formula Ia

$$[R^1 FeR^{2'}]_q^{\oplus} [LQ_m]^{q\ominus} \qquad (Ia)$$

wherein $R^1$, L, Q, m and q are as claimed in claim 1 and $R^{2'}$ is an anion of a $\pi$-arene, by reacting an uncharged $\pi$-complex of the formula IIIa

$$[(R^{2'})_2 Fe] \qquad (IIIa)$$

with a $\pi$-arene $R^1$ in the presence of aluminium and a Lewis acid and subsequently treating the reaction

product with a salt of the anion $[LQ_m]^{q-}$, which process comprises the use of $TiCl_4$ as Lewis acid.

15. A coated material which comprises on a substrate a coating of the compositions as claimed in either claim 1 or claim 10.

16. Use of a curable composition as claimed in either claim 1 or claim 10 for the production of cured products, which comprises heat-curing said composition direct.

17. Use of a curable composition as claimed in claim 1 for the production of cured products, which comprises first activating the initiator of the formula I by irradiation and then heat-curing the resultant activated precursor, such that the irradiation temperature is below the temperature employed for the subsequent heat-curing.

18. Use of a curable composition as claimed in claim 12 as hardener for cationically polymerisable organic materials.

**Revendications**

1. Compositions durcissables contenant :
A) une matière organique polymérisable par voie cationique, et
B) au moins un composé de formule I

$$[(R^1)(R^2 M)_a]^{+an} \frac{an}{q} [LQ_m]^{-q} \qquad (I)$$

dans laquelle a vaut 1 ou 2 et n et q sont chacun, indépendamment l'un de l'autre, un nombre entier valant 1 à 3, M représente le cation d'un métal monovalent à trivalent du groupe IVb à VIIb, VIII ou Ib du système périodique, m est un nombre entier correspondant à la valeur de L + q et Q représente un atome d'halogène, L est un métal ou non-métal divalent à heptavalent, $R^1$ est un arène-$\pi$ et $R^2$ est un arène-$\pi$ ou l'anion d'un arène-$\pi$.

2. Compositions selon la revendication 1, caractérisées en ce que $R^1$ et/ou $R^2$ représentent des groupes aromatiques ayant 6 à 24 atomes de carbone ou des groupes hétéroaromatiques ayant 3 à 20 atomes de carbone, ces groupes étant éventuellement substitués, de façon identique ou différente, une ou plusieurs fois par des atomes d'halogène, des groupes alkyle en $C_1$-$C_8$, alcoxy en $C_1$-$C_8$, cyano, alkylthio en $C_1$-$C_8$, ester d'acide monocarboxylique en $C_2$-$C_6$, phényle, alcanoyle en $C_2$-$C_5$ ou benzoyle.

3. Compositions selon la revendication 1, caractérisées en ce que $R^2$ représente l'anion d'un arène-$\pi$ aromatique ayant 6 à 24 atomes de carbone ou d'un arène-$\pi$ hétéroaromatique ayant 3 à 20 atomes de carbone, qui est éventuellement substitué, une ou plusieurs fois, par des groupes alkyle en $C_1$-$C_8$, ester d'acide monocarboxylique en $C_2$-$C_6$, cyano, alcanoyle en $C_2$-$C_5$ ou benzoyle identiques ou différents.

4. Compositions selon la revendication 1, caractérisées en ce que a vaut 2 et $R^2$ représente chaque fois l'anion d'un arène-$\pi$ et chaque M représente le même atome de métal.

5. Compositions selon la revendication 1, caractérisées en ce que a vaut 1 et $R^1$ représente un groupe benzène, toluène, xylène, méthoxybenzène, chlorobenzène, p-chlorotoluène, naphtalène, méthylnaphtalène, chloronaphtalène, méthoxynaphtalène, biphényle, indène, pyrène ou sulfure de diphényle, et $R^2$ représente l'anion du cyclopentadiène, de l'acétylcyclopentadiène ou de l'indène, ou un groupe benzène, toluène, xylène, triméthylbenzène, naphtalène ou méthylnaphtalène.

6. Compositions selon la revendication 1, caractérisées en ce que vaut 1, $R^1$ représente le pyrène-$\eta^6$ ou le naphtalène-$\eta^6$ et $R^2$ représente l'anion du cyclopentadiène-$\eta^5$, et n vaut 1 ou 2 et q vaut 1.

7. Compositions selon la revendication 1, caractérisées en ce que M représente un cation chrome, cobalt, manganèse, tungstène, molybdène ou fer, et $[LQ_m]^{-q}$ représente $SbF_6^-$, $SbF_4^-$, $AsF_6^-$ ou $PF_6^-$.

8. Compositions selon la revendication 1, caractérisées en ce qu'une résine époxyde est présente comme matière organique polymérisable par voie cationique.

9. Compositions selon la revendication 1, caractérisées en ce qu'un éther-oxyde diglycidylique d'un phénol divalent à chaîne éventuellement allongée, ou d'un dialcool aliphatique comportant 2 à 4 atomes de carbone est présent comme matière organique polymérisable par voie cationique.

10. Compositions durcissables activées, que l'on peut obtenir en exposant à un éclairage une composition durcissable selon la revendication 1, à une température inférieure à celle appliquée pour le durcissement subséquent à chaud.

11. Compositions selon la revendication 1 ou 10, caractérisées en ce qu'elles contiennent 0,1 à 15 % en poids, avantageusement 0,5 à 5 % en poids, par rapport à la matière A) organique polymérisable, d'au moins un composé de formule I.

12. Compositions selon la revendication 1 ou 10, caractérisées en ce qu'elles contiennent jusqu'à des quantités équimolaires d'un amorceur de formule I et d'une matière A) organique polymérisable, le terme équimolaire se fondant sur le groupe réactif de cette matière organique polymérisable.

13. Composés choisis dans l'ensemble constitué par le ($\eta^6$-toluène) ($\eta^5$-indényl)-fer(II)-hexafluorophosphate, le ($\eta^6$-pyrène) ($\eta^5$-cyclopentadiényl)-fer(II)-hexafluoroantimoniate, le ($\eta^6$-naphtalène) ($\eta^5$-cyclopentadiényl)-fer(II)-hexafluoroantimoniate, le ($\eta^6$-naphtalène) ($\eta^5$-cyclopentadiényl)-fer(II)-hexafluoroarséniate, le

($\eta^6$-2-méthoxynaphtalène) ($\eta^5$-cyclopentadiényl)-fer(II)-hexafluorophosphate, le (sulfure d'$\eta^6$-diphénylène) ($\eta^5$-cyclopentadiényl)-fer(II)-hexafluorophosphate, le ($\eta^6$-pérylène) ($\eta^5$-cyclopentadiényl)-fer(II)-hexafluorophosphate et le bis($\eta^6$-méthyl-1-naphtalène) fer(II)-hexafluorophosphate.

14. Procédé pour préparer des composés de formule Ia :

$$[R^1\, FeR^{2'}]_q^{\oplus}\ [LQ_m]^{q\ominus} \qquad \text{(Ia)}$$

dans laquelle $R^1$, L, Q, m et q ont les sens indiqués à la revendication 1 et $R^{2'}$ représente un anion d'un arène-$\pi$, par réaction d'un complexe-$\pi$ non chargé de formule IIIa :

$$[(R^{2'})_2\, Fe] \qquad \text{(IIIa)}$$

avec un arène-$\pi$ $R^1$ en présence d'aluminium et d'un acide de Lewis, puis traitement avec un sel de l'anion $[LQ_m]^{q-}$, procédé caractérisé en ce qu'on utilise comme acide de Lewis $TiCl_4$.

15. Matière enduite, caractérisée en ce qu'elle contient, sur un substrat, un enduit de compositions selon la revendication 1 ou 10.

16. Utilisation de compositions durcissables selon la revendication 1 ou 10 pour préparer des produits durcis, caractérisée en ce qu'on fait durcir directement à chaud ces compositions.

17. Utilisation de compositions durcissables selon la revendication 1 pour préparer des produits durcis, caractérisée en ce qu'on active tout d'abord, par exposition à un éclairage, l'amorceur de formule I et l'on fait ensuite durcir à chaud le précurseur activé obtenu, de manière que la température d'exposition à l'éclairage se situe au-dessous de la température utilisée pour le durcissement subséquent par chauffage.

18. Utilisation de compositions durcissables selon la revendication 12, comme durcisseurs pour des matières organiques polymérisables par voie cationique.